# EUROPEAN PATENT APPLICATION

(11) **EP 0 561 622 A2**
(43) Date of publication of application: **22.09.1993**
(21) Application number: 93302008.3
(22) Date of filing: 17.03.1993
(51) Int. Cl.: G11C 27/04

(54) **Integrated circuit delay line using a solid state image sensor**

(30) Priority: 18.03.1992 KR 924433
(71) Applicant: SAMSUNG ELECTRONICS CO., LTD., Suwon-city, Kyungki-do 441-373 (KR)
(72) Inventor: Woo, Jin Ju, Tongdaemun-gu, Seoul (KR); Lee, Tock Jae, 5-9, Sogyo-dong, Mapo-gu, Seoul (KR)
(74) Representative: Sturt, Clifford Mark

(57) **Abstract**

An integrated circuit delay line using solid state image sensors is disclosed. A transfer part includes a plurality of transfer devices for transferring signals, having a first CCD input terminal for a first (PAL) broadcasting mode and a second CCD input terminal for a second (NTSC) broadcasting mode. A plurality of clocking gates are provided, for selecting said first input terminal or said second input terminal and a control circuit controls said clocking gates in order to select a specific broadcasting mode signal

## Description

The present invention relates to an integrated circuit delay line using a solid state image sensor, which is capable of selectively delaying different types of image signals.

Known systems for processing different types of image signals, such as NTSC and PAL etc., use separate delay lines, given that the signals are transmitted at different clock frequencies, in order to delay an image signal by one horizontal scanline period (63.5µsec for NTSC or 64µsec for PAL)

Known systems, capable of processing NTSC and PAL signals, require separate chips for each said modes, thereby increasing the amount of circuitry which is specific to the PAL mode, along with circuitry which is specific to the NTSC mode

It is an object of the present invention provide an improved integrated circuit delay line. In particular, it is an object of the present invention to provide an integrated circuit delay line using a solid state image sensor which can select a signal of the desired broadcasting mode.

According to a first aspect of the present invention, there is provided an integrated circuit delay line using a solid state image sensor comprising:
transfer parts, including a plurality of transfer devices to transfer signals, having CCD input terminals for a first (PAL) broadcasting mode and having CCD input terminals for a second (NTSC) broadcasting mode; a plurality of clocking gates for selecting said CCD input terminals of said first broadcasting mode or said second broadcasting mode; and a control circuit for controlling gate and selecting a broadcasting mode signal.

The invention will now be described by way of example only, with reference to the accompanying drawings, in which:-
Figure 1 shows a layout of a delay line integrated circuit using a solid state image sensor, according to the present invention;
Figure 2 shows a diagram of a control circuit for selecting a CCD input terminal, for a PAL broadcasting mode or an NTSC broadcasting mode; and
Figure 3A and Figure 3B show a potential characteristic of the CCD input terminals, for PAL and NTSC broadcasting modes, in accordance with the present invention.

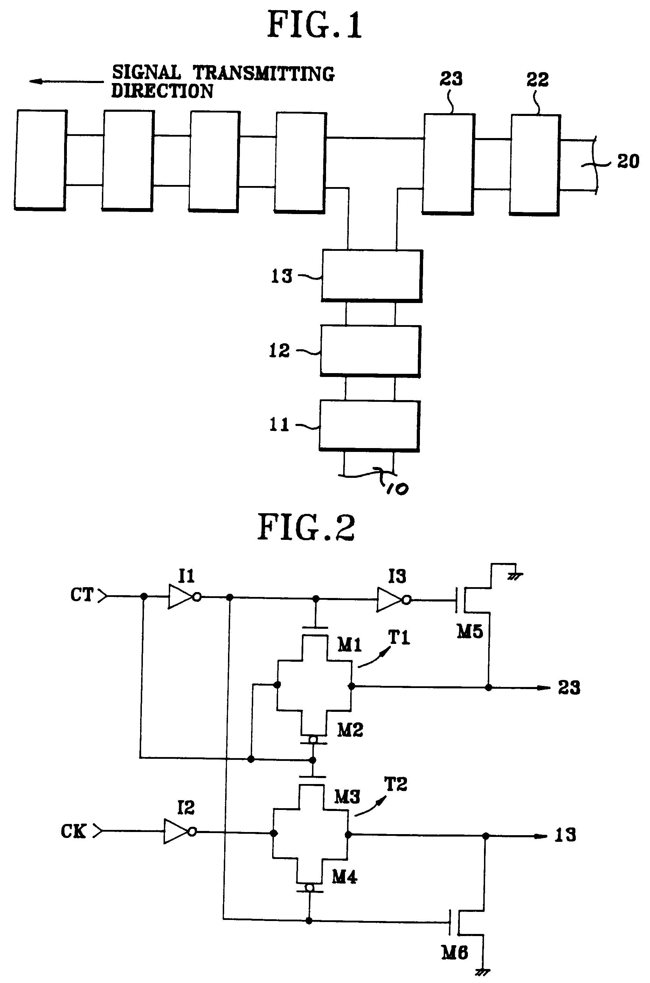

A layout for a delay line integrated circuit in a solid state image sensor is shown in Figure 1 and Figure 2 shows a diagram of a control circuit for selecting a CCD input terminal for a PAL broadcasting mode or an NTSC bnroadcasting mode.

As shown in Figure 1 a delay line integrated circuit using a solid state image sensor, includes a transfer gate, with input terminals which are divided into two parts, consisting of NTSC CCD terminal 20 and PAL CCD terminal 10.

The PAL and NTSC CCD terminals 10 and 20 are separately used for the particular application, although other parts of the CCD terminals are commonly used.

The control circuit shown in Figure 2 controls the clocking of gates 13 and 23, in order to adjustably select the two CCD terminals. The control signals CT is commonly input to a gate of a PMOS transistor M2 of a transfer gate T1 and a gate of an NMOS transistor to a transfer gate T2. The control signal CT is inverted by an inverter I1 and thereafter supplied to a gate of NMOS transistor M1 of the transfer gate T1, to a gate of NMOS transistor M5 through an inverter I3, connected in parallel to the gate, to a gate of PMOS transistor M4 of the transfer gate T2 and to the gate of NMOS transistor M6 connected in parallel to the gate.

The clock signals CK are inverted by the inverter 12 and input to the transfer gates T1 and T2. These signals are then output to the clocking gate for NTSC and PAL broadcasting modes, by NMOS transistor M5, connected to the output terminal of the transfer gate T1 and by NMOS transistor M6 connected to the output terminal of the transfer gate T2.

The PAL and NTSC CCD terminals 10 and 20 comprise a CCD terminal used commonly by the two broadcasting modes and CCD terminals used separately for each of the broadcasting modes, in which frequencies for the different broadcasting modes are selectively used to provide a delay equivalent to one horizontal scanline, (63.5µsec. for NTSC or 64µsec. for PAL).

Referring to Figure 2, the control circuit selectively controls the PAL and NTSC CCD terminals 10 and 20 as follows.

The control signal CT at a low state is input to the gate of the PMOS transistor M2 of the transfer gate T1, and, at the same time,the control signal is inverted to a signal with a high state by the inverter I1, for input to the gate of MOS transistor M1 of the transfer gate T1, thereby ensuring that transistors M1 and M2 are both turned on. At this time, the control signal CT, in its low state, is input to the gate of NMOS transistor M5, in its low state, by the inverter I1 and I3, so that the transistor M5 is turned off.

The clock signal CK inverted by inverter I2 and transferred to the clocking gate 23 for the NTSC broadcasting mode, via the turned on transfer gate T1, thereby selecting NTSC CCD terminal 20. Thus, when the control signal CT is in a low state, the clock signal CK clocks up and down a potential of lower well than of gate 23, along gates 21, 22 and 23 of Figure 23, thereby transferring the NTSC broadcasting mode.

When the control signal CT is placed into its low state and input to the gate of NMOS transistor M3 of the transfer gate T2, it is inverted to a signal with a high state by inverter I1. Thereafter, it is input to the gate of PMOS transistor M4 of the transfer gate T2, so that the transistors M3 and M4 are turned off. Again, at the same time, the control is input to the gate of NMOS transistor M6, with the high state being inverted through the inverter I1, resulting in transistor M6 being turned on. Therefore, the clock signal CK, inverted by the inverter I2, is cut off by the transfer gate T2, and the output signal of the transfer gate T2, in its turned off state, becomes a low state which is transferred to the clocking gate 13 for the PAL broadcasting mode, by which the PAL CCD terminal 10 is cut off.

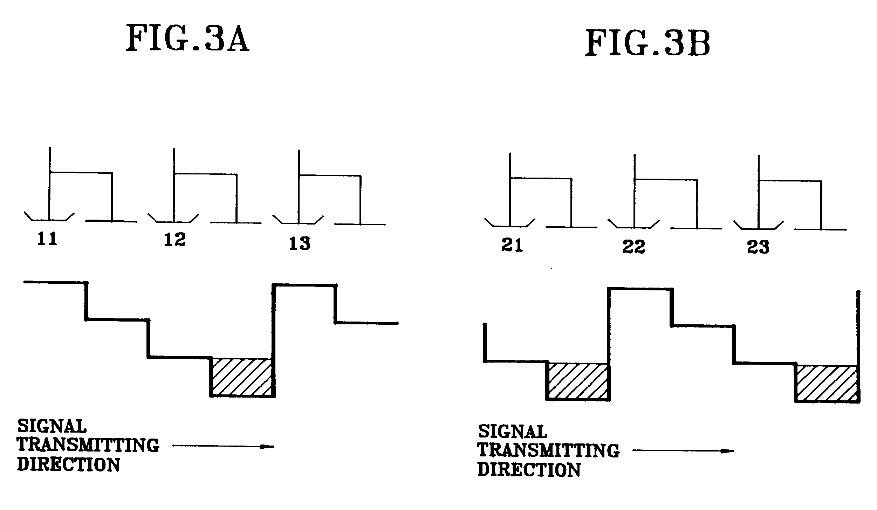

When the control signal CT is in its low state, the clock signal CK fixes a potential of the lower well of the gate 13, among the gates 11, 12 and 13 of Figure 3A, thereby cutting off the transfer of an image signal for the PAL broadcasting mode.

Operation of the control circuit for the control signal in a high state is substantially similar to that for the signal at a low state, as explained previously. The NMOS transistor M1 and PMOS transistor M2 of the transfer gate T1 are turned off by the control signal CT, in its high state, while NMOS trasistor M5 is turned on. In addition, NMOS transistor M3 and PMOS transistor M4 of the transfer gate T2 are turned off.

The clock signal CK, inverted by the inverter 12, passes transistors M3 and M4, turned on by a transfer gate T2 and transferred to the clocking gate 13 for the PAL broadcast mode, thereby opening PAL CCD terminal 10. That is, the clock signal CK clocks a potential of the lower well of the gate 13, among the gates 11, 12 and 13 of Figure 3A and transfers an image signal.

Meanwhile, the clock signal CK is cut off by the transfer gate T1, and an output signal of the transfer gate T1, in its turned-off state, becomes low and is transferred to the clocking gate 13, for the NTSC broadcasting mode, thereby cutting off NTSC CCD terminal 20. Thus, the clock signal CK cuts off transfer of the image signal of the NTSC broadcasting mode by fixing a potential of the lower well of the gate 23 among the gates 21, 22 and 23 of Figure 3B.

The integrated circuit delay line using a solid state image sensor of the present invention has an effect that the delay lines of different broadcasting modes may be made on a single chip, so that a signal of a desired broadcasting mode can be selected.

This invention is no way limited to the embodiment described hereinabove. Various modifications of the disclosed embodiment as well as other embodiments of the invention will become apparent to persons skilled in the art upon reference to the description of the invention.

## Claims

1. An integrated circuit delay line using solid state image sensors, comprising
a transfer part including a plurality of transfer devices for transferring signals, having a first CCD input terminal for a first (PAL) broadcasting mode and a second CCD input terminal for a second (NTSC) broadcasting mode;
a plurality of clocking gates for selecting said first input terminal or said second input terminal; and
a control circuit for controlling said clocking gates in order to select a specific broadcasting mode signal.

2. A delay line according to claim 1, wherein said CCD input terminals are integrated within a single chip.

3. A delay line according to claim 1, wherein said control circuit includes first and second transfer gates (T1 and T2) for blocking or passing the clock signals (CK) in accordance with a signal level of a control (CT) and for applying the clock signals to input terminals for the NTSC broadcasting mode or the PAL broadcasting mode.,

4. A delay line according to claim 3, wherein the clock signal is transferred to a desired clocking gate through a plurality of transfer gates controlled by said control circuit.
